(19) Europäisches Patentamt
European Patent Office
Office européen des brevets

(11) **EP 4 546 004 A1**

(12) **EUROPEAN PATENT APPLICATION**

(43) Date of publication:
**30.04.2025  Bulletin 2025/18**

(21) Application number: **24206562.1**

(22) Date of filing: **15.10.2024**

(51) International Patent Classification (IPC):
*G01S 7/481* (2006.01)   *H05K 9/00* (2006.01)

(52) Cooperative Patent Classification (CPC):
**G01S 7/4813; H01L 25/167; H05K 9/0045; H05K 9/0058**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.10.2023  FR 2311572**

(71) Applicant: **STMicroelectronics International N.V.**
**1228 Plan-les-Ouates, Geneva (CH)**

(72) Inventors:
• **MAO, Yandong**
**SHANGHAI, 200240 (CN)**

• **PRICE, Andrew John**
**BONNYRIGG, EH19 3BQ (GB)**
• **TEO, Tat Ming**
**797463 SINGAPORE (SG)**
• **BEIX, Vincent**
**73800 PORTE DE SAVOIE (FR)**
• **CATANIA, Justin**
**38100 GRENOBLE (FR)**

(74) Representative: **Cabinet Beaumont**
**4, Place Robert Schuman**
**B.P. 1529**
**38025 Grenoble Cedex 1 (FR)**

(54) **OPTICAL SENSOR MODULE**

(57)   The present disclosure relates to an optical sensor module (100) comprising:
- a light-emitting device (110);
- a module cap (130) adapted to at least partially cover the light-emitting device, the module cap (130) comprising a first opening (131) located over the light-emitting device;
- at least a conductive strip (134) assembled with, or included in, the module cap;
- a glass (150) positioned in the first opening and/or covering the first opening, and adapted to transmit light signals emitted by the light-emitting device, the glass including a conductive trace (152); and
- at least a conductive wire (155) formed by wire bonding, the at least one conductive wire electrically connecting the conductive trace to the at least one conductive strip.

Fig 1

## Description

Technical field

The present disclosure relates generally to optical sensors, in particular optical sensor modules.

Background art

Optical sensors, such as proximity sensors, may be used to detect the presence of nearby objects. Optical sensors are able to do so without physically touching the object. Some types of optical sensors, such as those utilized in optical ranging devices or time of flight sensors, may be used to determine the actual distance to such nearby objects. Optical sensors may be utilized in various electronic devices, such as cameras, phones, including smartphones, smartwatches, tablets, vehicles, machinery, and other devices for detecting the presence of and/or distance to nearby objects. After detecting the presence of the nearby object, the electronic device may be configured to perform a function, such as move a mechanical feature to a secure position, transmit an alarm signal, couple or uncouple an electrical communication, or any other desired function.

Optical sensors typically include components, such as a light-emitting device, a light-receiving sensor (or image sensor), and generally a processing device for processing signals received from the light-receiving sensor. The components of the optical sensor may be formed on a substrate, and a cap may be bonded to the substrate over the components, for example to protect them from damage, thereby forming an optical sensor module, also called optical sensor package. The cap is generally formed with a first opening located over the light-emitting device and a second opening located over the light-receiving sensor.

Generally described, the light-emitting device emits a light signal, or light beam, through the first opening. If an object is outside, and close enough to, the optical sensor module, the light signal may be reflected by the object towards the light-receiving sensor through the second opening. The light-receiving sensor may then generate an electrical signal indicative of the received light signal, which may be transmitted to the processing device for processing said received light signal, for example to determine the presence of, and/or distance to, the proximate object.

The light-emitting device used to generate the light beam is generally covered by a glass for protecting the device from dust, the glass being relatively transparent to light at the wavelengths used. The first opening, which is located over the light-emitting device, may be covered by the glass. The glass may also function as a diffuser suitable for reducing to some extent the intensity of the emitted light beam, for example for safety reasons, such as protecting a user. However, if the glass is detached, broken, or otherwise removed from over the light-emitting device, the intensity of the light-emitting device may be such that it risks causing harm, for example to a user's eyes.

There is a need for improving optical sensor modules, in particular to address the above-mentioned safety problem related to the light-emitting device.

There may also be a need for managing electromagnetic interferences (EMI) between an optical sensor module and another electronic device, in particular through the openings of the cap.

Summary of Invention

One embodiment addresses all or some of the drawbacks of known optical sensor modules.

One embodiment provides an optical sensor module comprising:

-   a light-emitting device;
-   a module cap adapted to at least partially cover the light-emitting device, the module cap comprising a first opening located over the light-emitting device;
-   at least a conductive strip assembled with, or included in, the module cap;
-   a glass positioned in the first opening or between the first opening and the light-emitting device, and/or covering the first opening, and adapted to transmit light signals emitted by the light-emitting device, the glass including a conductive trace; and
-   at least a conductive wire formed by wire bonding, the at least one conductive wire electrically connecting the conductive trace to the at least one conductive strip.

In an embodiment, the material of each conductive wire comprises one or a plurality of the following materials: gold, copper, aluminum, silver, or a tin alloy.

In an embodiment, the at least one conductive wire is configured to have a flexibility suitable for absorbing the dimensional changes between the glass, the module cap and the at least one conductive strip.

In an embodiment, the at least one conductive wire has a thickness lower than or equal to 40 pm, for example lower than or equal to 20 $\mu$m, and/or a length lower than or equal to 2 mm.

In an embodiment, the module further comprises a substrate with which the module cap is assembled, the at least one conductive strip being coupled to at least a first conductive pad of the substrate, for example using a conductive adhesive material.

In an embodiment, the substrate comprises a conductive rail configured to be at a fixed voltage, for example ground, the conductive rail being coupled to one of the at least one first conductive pad.

In an embodiment, the glass further includes at least a second conductive pad coupled to the conductive trace, for example the at least one second conductive pad is connected to an end of the conductive trace, the at least one conductive strip being coupled to the at least one second conductive pad using the at least one conductive wire.

In an embodiment, the at least one conductive wire and/or the bonding of said at least one conductive wire is arranged to be broken if the glass becomes detached from the module cap.

In an embodiment, the module further comprises a detection circuit adapted to detect when a conductive loop formed by the at least one conductive strip, the at least one conductive wire and the conductive trace is broken, the detection circuit being configured to deactivate the light-emitting device if it detects an open circuit in the conductive loop.

In an embodiment, the conductive trace provides electromagnetic interference shielding.

In an embodiment, the at least one conductive strip is inserted into at least one channel of the module cap.

In an embodiment, the at least one conductive strip is at least one conductive lead, for example at least one lead frame.

In an embodiment, the at least one conductive strip is at least one connecting flex overmolded in the module cap.

In an embodiment, the glass is a lens, or a lens pad, the glass for example comprising at least a beam shaper.

In an embodiment, the module cap:

- is an injection molded cap, the molding material being for example a resin; and/or
- is a plastic module cap; and/or
- comprises a material suitable for providing electromagnetic interference shielding.

In an embodiment, the module further comprises:

- a light-receiving sensor at least partially covered by the module cap, the module cap comprising a second opening located over the light-receiving sensor; and
- a filter in the second opening, or covering the second opening, and adapted to transmit the light signals reflected towards the light-receiving sensor; the filter for example including a second conductive trace providing electromagnetic interference shielding.

Brief description of drawings

The foregoing features and advantages, as well as others, will be described in detail in the following description of specific embodiments given by way of illustration and not limitation with reference to the accompanying drawings, in which:

Figure 1 is a 3-dimensional view of an optical sensor module according to an embodiment;

Figure 2A and Figure 2B are 3-dimensional views of the module cap of the optical sensor module of Figure 1; and

Figure 3A, Figure 3B, Figure 3C and Figure 3D are 3-dimensional and top views illustrating a method of forming the optical sensor module of Figure 1.

Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, all the components of an optical sensor have not been detailed, the described embodiments being compatible with the usual optical sensors. For example, the light-emitting device, the light-receiving sensor, and other components of an optical sensor, such as a processing device, have not been detailed. Similarly, all the components of an optical sensor module have not been detailed, the described embodiments being compatible with the usual optical sensor modules.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures, or to an optical sensor module as orientated during normal use.

Unless specified otherwise, the expressions "around", "approximately", "substantially" and "in the order of" signify within 10 %, and preferably within 5 %.

In the following disclosure, unless indicated otherwise, when reference is made to a glass, this includes an element made of a material which is relatively transparent to light at the wavelengths used, for example has a transmission rate of 90 percent or more for these wavelengths. This includes, without being limited to, a glass material or plastic material. The glass may be formed of a solid single material, or may be formed by assembling multiple materials, in which case only part of the glass may be in a transparent material. The glass may comprise, or consist in, a lens or a plurality of lenses, and/or an optical filter.

In the following disclosure, unless indicated otherwise, when reference is made to a filter, reference is made to an optical filter.

In the following disclosure, unless indicated otherwise, when reference is made to a conductive element, for example a conductive trace, pad, strip or lead, reference is made to an electrically conductive element.

The term "optical sensor module" includes, without being limited to, a proximity sensor module, a time of flight (ToF) module, an ambient light sensor (ALS) module, a 3D Lidar module, and/or a camera module. The term "optical sensor module" also includes an optical sensor module with combined functions, for example a combination of at least two of the above-mentioned modules, or other functions, for example a combination of a proximity detector module with a floodlight and/or a dot projector.

The embodiments relate to optical sensor modules. An optical sensor typically includes a light-emitting device, comprising for example a light emitting diode (LED), and/or a laser such as a vertical cavity surface emitting laser (VCSEL), and a light-receiving sensor, comprising for example a photodiode or a plurality of photodiodes. An optical sensor generally also includes a processing device for processing signals received from the light-receiving sensor. The light-emitting device and the light-receiving sensor may be formed on a substrate, and a cap may be bonded to the substrate over the light-emitting device and the light-receiving sensor, thereby forming an optical sensor module, also called optical sensor package. The cap is generally formed with a first opening located over the light-emitting device and a second opening located over the light-receiving sensor.

As explained in the background section above, the light-emitting device used to generate the light beam is generally covered by a glass for protecting the device, for example from dust, the glass being relatively transparent to light at the wavelengths used. The glass may cover the first opening. The glass may also function as a diffuser suitable for reducing to some extent the intensity of the emitted light beam, for example for safety reasons, such as protecting a user. However, if the glass is detached, broken, or otherwise removed from over the light-emitting device, the light-emitting device will no longer be covered, exposing a user to the full intensity of the light beam.

In order to address this safety problems related to the light-emitting device, the glass may include a conductive trace over the light emitting device. Generally, the conductive trace is arranged to be coupled to a conductive rail configured to be at a fixed voltage, the conductive rail being generally connected to, or included in, the substrate. This may be done through one or several conductive element(s) in the cap, for example through one or several lead frame(s). In such a case, a coupling between the conductive trace and the conductive element(s) in the cap is provided. One solution is to use a conductive glue between the conductive trace and the conductive element(s). However, the coupling using a conductive glue may be subjected to dimensional changes between the glass and the cap, which may be due to different coefficients of thermal expansion (CTE), and there is a risk of breakage.

The inventors propose an optical sensor module making it possible to overcome all or part of the aforementioned drawbacks, in particular to improve the coupling between a conductive trace in a glass and a substrate, for example the coupling between the conductive trace and conductive element (s) in a cap bonded to the substrate. It may be desirable that the solution is adapted to address the safety problem related to the light-emitting device.

Embodiments of optical sensor modules will be described below. These embodiments are non-limiting and various variants will appear to the person skilled in the art from the indications of the present description.

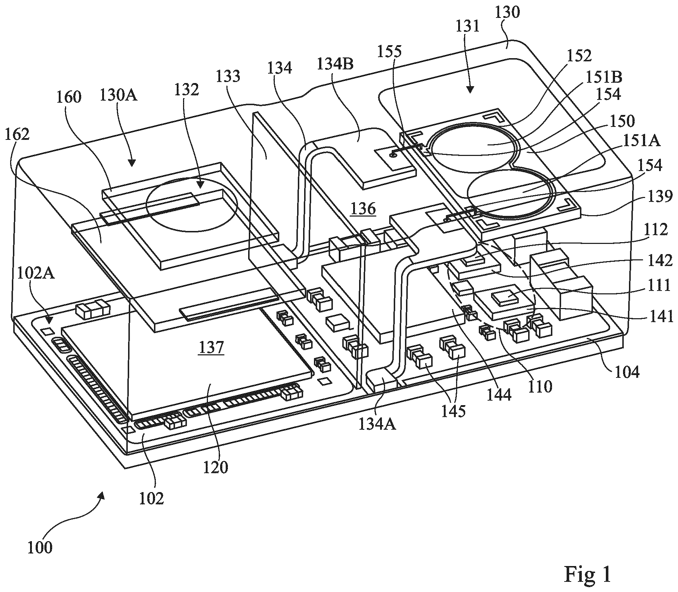

Figure 1 is a 3-dimensional view of an optical sensor module according to an embodiment.

The optical sensor module 100 comprises a light-emitting device 110, for example comprising a LED such as an infrared LED and/or a laser such as a VCSEL, and a light-receiving sensor 120, or image sensor, for example comprising a photodiode or a plurality of photodiodes, such as SPAD(s). The light-emitting device 110 and the light-receiving sensor 120 are mounted over a substrate 102.

The substrate 102 may be a printed circuit board (PCB).

The light-emitting device 110 is configured to emit light signals at a particular frequency or frequency range, and the light-receiving sensor 120 is adapted to detect the emitted light signals in return, for example reflected by an object. In one embodiment, the light-emitting device 110 is configured to emit infrared (IR) light signals, and the light-receiving sensor 120 is adapted to detect the IR light signals in return, for example reflected by an object.

The light-emitting device 110 of Figure 1 comprises first and second light sources 111, 112 each mounted on respectively a first interposer 141 and a second interposer 142, the first and second interposers 141, 142 being mounted on a top surface 102A of the substrate 102. The first and second light sources 111, 112 are for example first and second VCSELs. In a variant, the light sources may be mounted on the substrate without interposers.

In a variant, the light-emitting device may comprise only one light source, for example a VCSEL, for example mounted on an interposer.

The light-emitting device 110 may be electrically coupled to the light-receiving sensor 120, for example through the substrate 102.

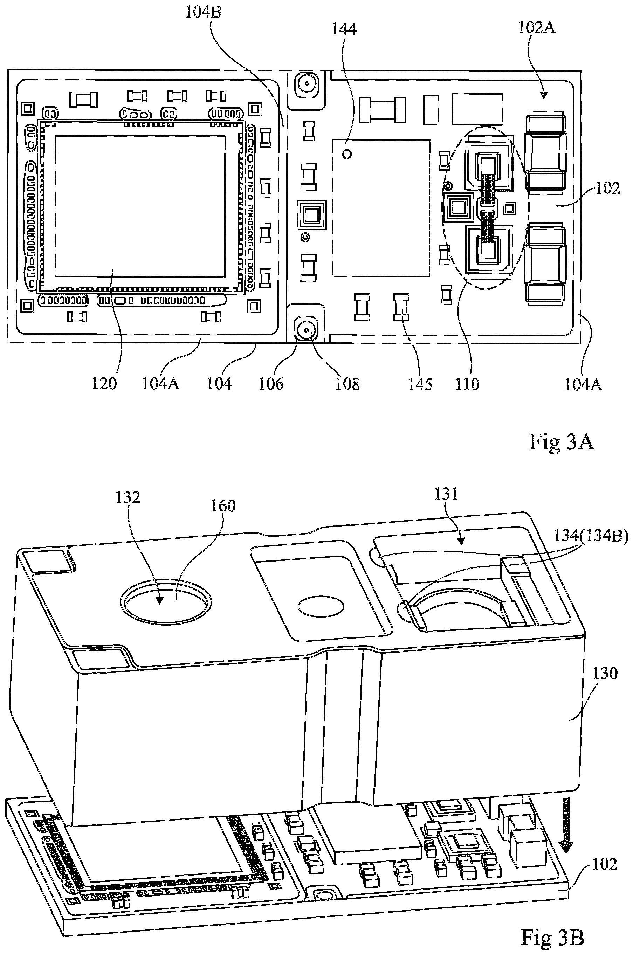

The top surface 102A of the substrate 102 includes first conductive pads 106 which are for example at, or close to, edges of the substrate (not shown in Figure 1, but shown in Figure 3A).

The optical sensor module 100 comprises a laser driver 144, configured for controlling the first and second light sources 111, 112. The laser driver 144 may be located in a same cavity as the light-emitting device 110, as described hereafter. This is not limitative and the person skilled in the art can contemplate other configurations.

The optical sensor module 100 may comprise a processing circuit (not shown in Figure 1) which may be configured for processing the light signals emitted by the light-emitting device 110 and received by the light-receiving sensor 120. The processing circuit may be mounted on the top surface 102A of the substrate 102.

The optical sensor module 100 includes other electrical circuits, or components, such as surface mounted technology (SMT) components 145 which are also mounted on the top surface 102A of the substrate 102. The SMT components 145 may comprise resistors. Other SMT components may comprise capacitors.

The light-receiving sensor 120 may be coupled to the substrate 102 using conductive connectors, for example conductive wires, and/or may be secured to the substrate 102, such as by an adhesive material or a solder. The adhesive material may be any material suitable for securing the light-receiving sensor 120 to the substrate, such as tape, paste, glue.

A module cap 130 having a first opening 131 and a second opening 132 is attached, or bonded, to the substrate 102 and is adapted to at least partially enclose, or cover, the components which are mounted on the substrate 102, at least the light-emitting device 110, the light-receiving sensor 120, the interposers 141, 142, the laser driver 144 and the SMT components 145. At least partially means that all the components may be not covered, for example the first and second openings do not cover the components which are under said openings. The module cap 130 may be substantially opaque to light at the wavelengths used.

For example, the module cap 130 is mounted on an opaque adhesive 104 which is positioned on the substrate 102.

The first and second openings are located at the top side 130A of the module cap 130. The first opening 131 is located over the light-emitting device 110 and the second opening 132 is located over the light-receiving sensor 120. In the illustrated example, the first opening 131 is rectangular and the second opening 132 is circular, but this is not limitative and other forms are possible.

The module cap 130 may include a separation wall 133 between the light-emitting device 110 and the light-receiving sensor 120. The separation wall 133 may form an optical isolator for substantially preventing the internal propagation of light beams between the light-emitting device 110 and the light-receiving sensor 120 within the module cap 130. For example, the separation wall 133 defines first and second cavities 136, 137, the first cavity 136 including the first opening 131 above the light-emitting device 110, and the second cavity 137 including the second opening 132 above the light-receiving sensor 120. The laser driver 144 may be located in the first cavity 136, together with the light-emitting device 110, as indicated above.

The module cap 130 may be a plastic cap, and/or a molded cap formed of a molding material, such as a resin, a Liquid Crystal Polymer (LCP), Nylon, or another engineering plastic. The module cap 130 may be formed using an injection method.

The optical sensor module 100 further comprises:

- a glass 150 positioned in the first opening 131, or between the first opening 131 and the light-emitting device 110, and adapted to transmit the light signals emitted by the light-emitting device; and
- a filter 160, positioned in the second opening 132, or between the second opening 132 and the light-receiving sensor 120, and adapted to transmit the light signals reflected towards the light-receiving sensor.

The glass 150 preferably covers the first opening 131. The glass 150 is preferably attached to the module cap 130. For example, the glass 150 sits on a mounting 139 which is formed within the first opening 131, and is mounted outside the module cap 130. In a variant, the glass could be mounted inside the module cap.

Similarly, the filter 160 preferably covers the second opening 132. The filter 160 is preferably attached to the module cap 130. For example, the filter 160 is positioned inside the module cap 130. In a variant, the filter could be mounted outside the module cap.

The glass 150 may comprise two optical surfaces which may be two beam shapers 151A, 151B, a first beam shaper 151A located over the first light source 111, and a second beam shaper 151B located over the second light source 112. The glass 150 may be a lens, or a lens pad.

The optical sensor module 100 may further comprise a second lens 162 between the filter 160 and the light-receiving sensor 120.

The glass 150 includes a conductive trace 152, which may be embedded in said glass. The glass 150 further includes second conductive pads 154 coupled to the conductive trace 152, for example two second conductive pads, each at an end of the conductive trace.

The conductive trace may be called "trace" in the following disclosure. The conductive pads may be called "pads" in the following disclosure.

The trace 152 and the second pads 154 of the glass 150 may be implemented by a same conductive coating, formed for example using a photolithography process. Examples of process flows for forming the trace 152 and the second pads 154 of the glass 150 are:

- a subtractive process, that is, in the following order: metal deposition, photolithography, etching and stripping;
- additive process, or lift-off, that is, in the following order: photolithography, metal deposition and stripping; or
- micro-molding, that is, in the following order: metal deposition, photolithography, electrodeposition, stripping and etching.

The conductive trace 152 of the glass 150 may be used in a safety function related to the light-emitting device.

In a variant, the filter 160 may also include a second conductive trace, which may also be used as a protection against electromagnetic interferences in the second opening 132 of the module cap 130, for example by providing EMI reflection in said second opening.

The conductive trace material may be one or a plurality of the following materials: copper (Cu), aluminum (Al), tungsten (W), titanium (Ti), gold (Au), indium-tin oxide (ITO) or another metal or metal alloy.

The conductive trace may be a fine and/or thin trace, for example having a width less than 1 micrometer and/or a thickness less than 100 nanometers, without being limited to these values. The width and thickness of each conductive trace may be a trade-off between the safety function and the optical transmittivity of the glass. For example, the trace could be wider and/or thicker where the trace is not likely to limit light transmission, and could be finer and/or thinner where the trace may limit light transmission.

The optical sensor module 100 further comprises two conductive leads 134, assembled to the module cap 130. The conductive leads 134 are configured and positioned in order to electrically couple the conductive trace 152 of the glass 150 to the substrate 102. Conductive leads 134 are for example lead frames.

Each conductive lead 134 may be a single conductive piece, for example a single metallic piece.

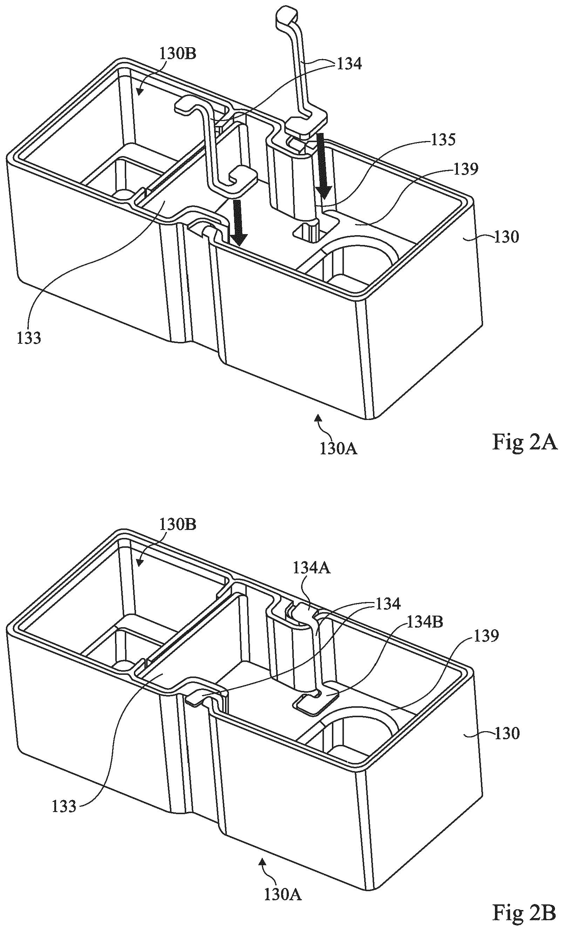

Each conductive lead 134 may be inserted into recesses, or channels, 135 formed in the module cap 130 (shown in Figures 2A and 2B).

In a variant, the conductive leads may be overmolded during an injection molding operation for forming the module cap. The conductive leads are then overmolded in the module cap.

Each conductive lead 134 comprises a first end 134A coupled, for example connected, to the substrate 102 through one of the first conductive pads 106, and a second end 134B coupled, for example connected, to the conductive trace 152 through one of the second conductive pads 154. The first end 134A of each conductive lead 134 may be coupled to one of the first conductive pads 106 by a conductive adhesive material 108, for example a conductive tape, paste or glue, or a conductive solder (not shown in Figure 1, but shown in Figure 3A) .

The second end 134B of each conductive lead 134 is coupled to the second conductive pads 154 by a conductive wire 155 formed by wire bonding, which may be called a "wire bond".

Therefore, the conductive leads 134 are coupled to the conductive trace 152, through the second conductive pads 154, using the wire bonds 155.

The conductive wires 155 are preferably flexible enough, for example to absorb the dimensional changes between the glass 150, the module cap 130 and the conductive leads 134, which may be due to different coefficients of thermal expansion (CTE). Indeed, a key function of the conductive wires 155 is to provide a flexible connection between the conductive leads 134 and the module cap 130, in particular between the conductive leads 134 and the second conductive pads 154 on the glass 150. Yet, one of the main parameters which have an impact on the flexibility is the diameter of the conductive wire. More precisely, the smaller the diameter, the greater the flexibility.

For example, the conductive wires 155 have a thickness comprised between 20 and 40 $\mu$m or even less than 20 $\mu$m.

The conductive wires 155 may have a length of about 2 mm, or less than 2 mm.

The material of the conductive wires 155 may be one or a plurality of the following materials: gold, copper, aluminum, silver, or even a tin alloy.

Advantages of using conductive wires formed by wire bonding are:

- the connection can be mechanically and electrically stable and withstand CTE difference;
- wire bonding is a mature technology, easily controllable and can provide various wire shapes and lengths;
- wire bonding is a clean technology with a low contamination risk of the glass;
- the conductive wires formed by wire bonding allow the glass, for example the lens or lens pad, to be close to the first opening of the module cap.

In addition, coupling the conductive wires 155 to the conductive leads 134, instead of coupling the conductive wires directly to the substrate 102 allow the conductive wires to be shorter. An advantage of having shorter conductive wires is to avoid shortage with other components.

In Figure 1, two conductive leads and two conductive wires have been represented. This is not limitative, and the optical sensor module may comprise one conductive lead and one conductive wire formed by wire bonding and coupling the conductive trace to the conductive lead. The optical sensor module may also comprise more than two conductive leads and more than two conductive wires.

In a variant, each conductive lead may be replaced by a connecting flex. Examples of connecting flex are described in more detail in the French patent application number 2311581, filed on October 25, 2023 in the name of STMICROELECTRONICS INTERNATIONAL N.V. (law firm reference being B22927), and in the European patent application claiming the priority of the French patent application number 2311581, which are hereby incorporated by reference to the maximum extent allowable by law.

The conductive lead and the connecting flex may be called "conductive strip".

The conductive trace 152 of the glass 150, together with the conductive wires 155, may be used in a protection mechanism to address the above-mentioned safety problem related to the light-emitting device 110.

Each conductive wire 155, and/or the bonding of each conductive wire 155, may function as a fuse. The bonding of the conductive wire corresponds to its connection, when formed by wire bonding, with the conductive trace 152 and/or the conductive lead 134.

Indeed, the conductive wire 155, and/or the bonding of each conductive wire 155, may be arranged to be broken if the glass 150 is removed or otherwise becomes detached from the module cap 130. The term "fuse" is used because the conductive wire, and/or the bonding of each conductive wire, may be designed to break an electrical connection in order to provide a protection mechanism. In particular, the fuse is configured to break in the event of a mechanical force caused by the detachment of the glass. To this effect, the conductive wires may have a diameter or thickness of 25 μm or less, and for example of 15 μm or less, thereby rendering it relatively fragile and likely to break if the glass is detached, and/or the bonding of the conductive wires may be formed relatively fragile and likely to break if the glass is detached.

Figure 2A and Figure 2B are 3-dimensional views of the module cap 130 of the optical sensor module 100 of Figure 1. More precisely, Figures 2A and 2B show the assembly of the conductive leads 134 into the channels 135 of the module cap 130. The module cap 130 is shown with its bottom side 130B facing upwardly and its top side 130A facing downwardly.

Figure 2A shows the insertion of the conductive leads 134 into the channels 135 and Figure 2B shows the final assembly of the conductive leads 134 in the channels 135 of the module cap 130. The first and second ends 134A, 134B of the conductive leads 134 protrude outside the module cap 130, for example in order to be coupled to respectively the substrate 102 and the conductive trace 152.

The module cap 130 may be painted of plated, for example to provide an EMI protection, preferably before inserting the conductive leads 134 to avoid contaminating the conductive leads.

The substrate 102 may comprise a conductive rail (not shown in Figure 1) configured to be at a fixed voltage, such as ground, so that the conductive trace 152 in the glass 150 can be coupled to the fixed voltage, through the conductive leads 134 and the substrate 102, and for example through some of the first and second conductive pads.

By combining the glass 150 with an optical surface, such as a lens and/or a filter, the optical sensor module 100 can additionally provide any optical function such as filtering, beam shaping and/or imaging, while reducing the total number of elements in the module.

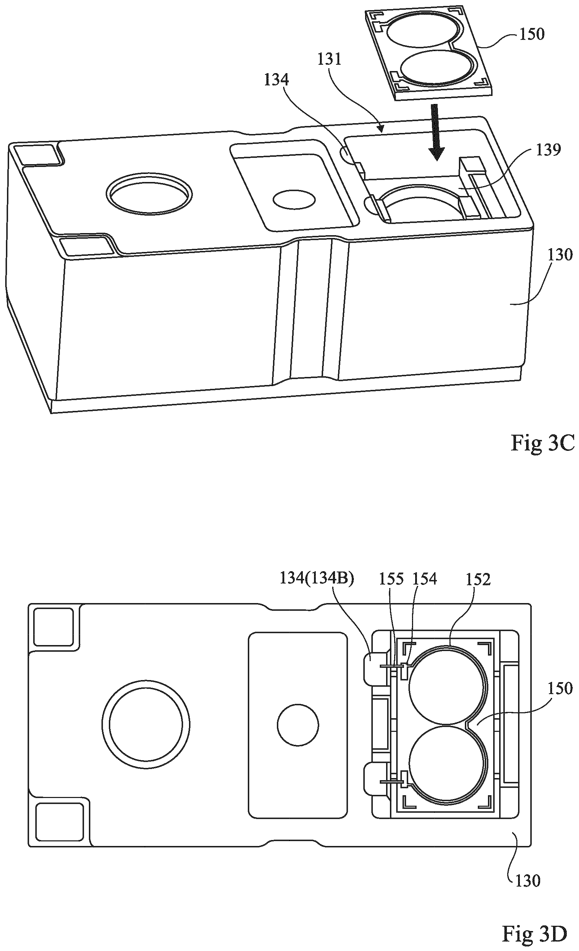

Figure 3A, Figure 3B, Figure 3C and Figure 3D are 3-dimensional and top views illustrating a method of forming the optical sensor module 100 of Figure 1.

Figure 3A shows, in a top view, a starting substrate 102, on which components are already mounted, at least the light-emitting device 110, the light-receiving sensor 120, the interposers 141, 142, the laser driver circuit 144 and the SMT components 145. The substrate 102 may be a printed circuit board.

The top surface 102A of the substrate 102 includes first conductive pads 106 which are at, or close to, edges of the substrate.

An adhesive material 104, for example an opaque adhesive material such as an opaque glue, is formed on the top surface 102A of the substrate 102. An edge part 104A of the adhesive material 104 is formed on edges of the top surface 102A, and a central part 104B of the adhesive material 104 is formed on a central part of the top surface 102A between the light-receiving sensor 120 and the laser driver 144/the light-emitting device 110, defining the future first and second cavities 136, 137.

A conductive material 108, for example a conductive solder or a conductive adhesive, is deposited on the first conductive pads 106.

Figure 3B shows, in a 3-dimensional view, the assembly of the module cap 130, having the first opening 131, the second opening 132 and the separation wall 133 (not shown in Figure 3B), to the substrate 102. The filter 160 may be already attached to the module cap 130. The conductive leads 134 are already assembled to the module cap 130, for example as described in relation with Figures 2A and 2B. Figure 3B shows mostly the second ends 134B of the conductive leads 134, which protrude outside the module cap 130.

During the assembly, bottom surfaces of sidewalls of the module cap 130 are brought into contact with the edge part 104A of the adhesive 104, in order to be bonded to the substrate 102, and the separation wall 133 of the module cap 130 is brought into contact with the central part 104B of the adhesive 104, forming the first and second cavities 136, 137.

The assembly of the module cap 130 and the substrate 102 may then be cured as appropriate, either by heat, UV light, or another appropriate cure technique, in order to fully cure the adhesive materials, and secure the assembly. For example, this assembly may be reflowed.

Figure 3C shows, in a 3-dimensional view, the assembly of the glass 150 on the mounting 139 into the first opening 131 of the module cap 130.

Figure 3D shows, in a top view, the assembly of the conductive wires 155 to the second ends 134B of the conductive leads 134 and to the second conductive pads 154 of the glass 150, using a wire bonding technique.

The optical sensor module 100 may comprise a detection circuit adapted to detect an open circuit corresponding to a detachment of the glass 150 from the module cap 130.

The detection circuit may be coupled to the conductive trace 152 and the conductive wires 155 through the conductive leads 134. The detection circuit may be implemented on and/or in the substrate 102. When the glass 150 is in position, and the conductive wires 155, as well as the bonding of the conductive wires 155, are intact, the conductive leads 134, the conductive wires 155 and the conductive trace 152 form a conductive loop, for example through conductive paths in the substrate 102. If, however, the glass 150 becomes detached, at least one of the conductive wires 155, and/or the bonding of at least one of the conductive wires 155, may be broken, leading to an open circuit in the conductive loop.

The detection circuit may be configured to control the light-emitting device 110, for example may deactivate the light-emitting device 110 if an open circuit is detected in the conductive loop. The detection circuit for example periodically or continuously tests the conductive loop, for example by passing a current through them, and may deactivate the light-emitting device 110 if an open circuit is detected in the conductive loop.

In addition to the safety problem related to the light-emitting device, the embodiments can have other applications. For example, the embodiments can be used for managing electromagnetic interferences (EMI) of the optical sensor module with another electronic device.

For example, when the optical sensor module is included in an electronic device (host device), electromagnetic interferences may occur between the optical sensor module and the host device. The electronic device may be a camera, a phone, for example a smartphone, a smartwatch, a tablet, a vehicle, a machinery, or another device for which it may be useful to detect the presence of and/or distance to nearby objects.

In particular, the conductive trace may be used as a protection against electromagnetic interferences (EMI) through the first opening of the module cap, for example by providing EMI reflection in said first opening.

The pitch and pattern of the conductive trace can be determined according to the frequencies of the EMI to be managed. For example, the higher frequency, the lower the pitch can be.

The pitch between the trace is for example smaller than the wavelength $\lambda$ of the signal to be attenuated, and is for example a fraction of the wavelength $\lambda$, where $\lambda$ is equal to:

$$\lambda = {}^{v}\!/_{f}$$

where v is the speed of light and f is the frequency of the electromagnetic wave chosen to be attenuated.

Advantageously, the conductive trace can be coupled to a fixed voltage, for example ground, for example to provide additional EMI protection.

Examples of conductive trace are described in more detail in the French patent application number 2311561, filed on October 25, 2023 in the name of STMICROELECTRONICS INTERNATIONAL N.V. (law firm reference being B22689), and in the European patent application claiming the priority of the French patent application number 2311561, which are hereby incorporated by reference to the maximum extent allowable by law.

Various embodiments and variants have been described. Those skilled in the art will understand that certain features of these embodiments can be combined and other variants will readily occur to those skilled in the art. For example, instead of being inserted into channels in the module cap, the conductive leads may be conductive layers formed on surfaces of the module cap. The conductive layers may be coated, or plated, on the module cap, for example formed using a laser direct structuring (LDS) technique.

Finally, the practical implementation of the embodiments and variants described herein is within the capabilities of those skilled in the art based on the functional description provided hereinabove.

## Claims

1. An optical sensor module (100) comprising:

   - a light-emitting device (110);
   - a module cap (130) adapted to at least partially cover the light-emitting device, the module cap (130) comprising a first opening (131) located over the light-emitting device;
   - at least a conductive strip (134) assembled with, or included in, the module cap;
   - a glass (150) positioned in the first opening or between the first opening and the light-emitting device, and/or covering the first opening, and adapted to transmit light signals emitted by the light-emitting device, the glass including a conductive trace (152); and
   - at least a conductive wire (155) formed by wire bonding, the at least one conductive wire electrically connecting the conductive trace to the at least one conductive strip.

2. The module (100) according to claim 1, wherein the material of each conductive wire (155) comprises one or a plurality of the following materials: gold, copper, aluminum, silver, or a tin alloy.

3. The module (100) according to claim 1 or 2, wherein the at least one conductive wire (155) has a thickness lower than or equal to 40 pm, for example lower than or equal to 20 μm, and/or a length lower than or equal to 2 mm.

4. The module (100) according to any of claims 1 to 3, further comprising a substrate (102) with which the module cap (130) is assembled, the at least one conductive strip (134) being coupled to at least a first conductive pad (106) of the substrate, for example using a conductive adhesive material (108) .

5. The module (100) according to claim 4, wherein the substrate (102) comprises a conductive rail configured to be at a fixed voltage, for example ground, the conductive rail being coupled to one of the at least one first conductive pad (106).

6. The module (100) according to any of claims 1 to 5, wherein the glass (150) further includes at least a second conductive pad (154) coupled to the conductive trace (152), for example the at least one second conductive pad is connected to an end of the conductive trace, the at least one conductive strip (134) being coupled to the at least one second conductive pad using the at least one conductive wire (155).

7. The module (100) according to any of claims 1 to 6, wherein the at least one conductive wire (155) and/or the bonding of said at least one conductive wire is arranged to be broken if the glass (150) becomes detached from the module cap (130).

8. The module according to claim 7, further comprising a detection circuit adapted to detect when a conductive loop formed by the at least one conductive strip (134), the at least one conductive wire (155) and the conductive trace (152) is broken, the detection circuit being configured to deactivate the light-emitting device (110) if it detects an open circuit in the conductive loop.

9. The module (100) according to any of claims 1 to 8, wherein the conductive trace (152) provides electromagnetic interference shielding.

10. The module (100) according to any of claims 1 to 9, wherein the at least one conductive strip (134) is inserted into at least one channel (135) of the module cap (130).

11. The module (100) according to any of claims 1 to 10, wherein the at least one conductive strip (134) is at least one conductive lead, for example at least one lead frame.

12. The module according to any of claims 1 to 10, wherein the at least one conductive strip is at least one connecting flex overmolded in the module cap.

13. The module according to any of claims 1 to 12, wherein the glass is a lens, or a lens pad, the glass for example comprising at least a beam shaper (151A; 151B).

14. The module (100) according to any of claims 1 to 13, wherein the module cap (130):

    - is an injection molded cap, the molding material being for example a resin; and/or
    - is a plastic module cap; and/or
    - comprises a material suitable for providing electromagnetic interference shielding.

15. The module (100) according to any of claims 1 to 14, further comprising:

    - a light-receiving sensor (120) at least partially covered by the module cap (130), the module cap comprising a second opening (132) located over the light-receiving sensor; and
    - a filter (160) in the second opening (132), or covering the second opening (132), and adapted to transmit the light signals reflected towards the light-receiving sensor; the filter for example including a second conductive trace providing electromagnetic interference shielding.

Fig 1

Fig 2A

Fig 2B

Fig 3A

Fig 3B

Fig 3C

Fig 3D

**Europäisches Patentamt**
**European Patent Office**
**Office européen des brevets**

# EUROPEAN SEARCH REPORT

Application Number

EP 24 20 6562

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/066036 A1 (SHI WEI [US] ET AL) 3 March 2022 (2022-03-03) * paragraphs [0004], [0006], [0017], [0018], [0058], [0059], [0061], [0062]; figures 1A, 2A, 5A, 5B * | 1-15 | INV. G01S7/481 H05K9/00 |
| A | US 2021/175180 A1 (MISCHKE COLLEEN F [US] ET AL) 10 June 2021 (2021-06-10) * paragraphs [0019], [0020]; figure 1B * | 1 | |
| A | EP 1 944 807 A1 (ST MICROELECTRONICS RES & DEV [GB]) 16 July 2008 (2008-07-16) * paragraphs [0007], [0022], [0024] * | 9 | |
| A | US 2019/157469 A1 (SAXOD KARINE [FR] ET AL) 23 May 2019 (2019-05-23) * paragraphs [0060], [0061]; figure 1 * | 15 | |

TECHNICAL FIELDS
SEARCHED (IPC)

G01S
H05K

The present search report has been drawn up for all claims

| Place of search | Date of completion of the search | Examiner |
|---|---|---|
| Munich | 27 February 2025 | Kirscher, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 6562

This annex lists the patent family members relating to the patent documents cited in the above-mentioned European search report.
The members are as contained in the European Patent Office EDP file on
The European Patent Office is in no way liable for these particulars which are merely given for the purpose of information.

27-02-2025

| Patent document cited in search report | Publication date | Patent family member(s) | | Publication date |
|---|---|---|---|---|
| US 2022066036 A1 | 03-03-2022 | CN | 114122904 A | 01-03-2022 |
| | | US | 2022066036 A1 | 03-03-2022 |
| US 2021175180 A1 | 10-06-2021 | NONE | | |
| EP 1944807 A1 | 16-07-2008 | NONE | | |
| US 2019157469 A1 | 23-05-2019 | CN | 109830472 A | 31-05-2019 |
| | | CN | 209056485 U | 02-07-2019 |
| | | FR | 3073980 A1 | 24-05-2019 |
| | | US | 2019157469 A1 | 23-05-2019 |
| | | US | 2020303565 A1 | 24-09-2020 |
| | | US | 2022029034 A1 | 27-01-2022 |

EPO FORM P0459

**REFERENCES CITED IN THE DESCRIPTION**

**Patent documents cited in the description**

- FR 2311581

- FR 2311561